Europäisches Patentamt

European Patent Office

Office européen des brevets

(19)

(11) Numéro de publication : **0 017 596**
**B1**

(12) # FASCICULE DE BREVET EUROPÉEN

(45) Date de publication du fascicule du brevet :
03.04.85

(21) Numéro de dépôt : 80400472.9

(22) Date de dépôt : 09.04.80

(51) Int. Cl.⁴ : **G 01 S   7/48, H 01 J  43/30,
H 01 L  31/10, H 03 G   3/20,
H 04 B   9/00**

(54) **Dispositif photorécepteur à faible bruit.**

(30) Priorité : 10.04.79 FR 7909057

(43) Date de publication de la demande :
15.10.80 Bulletin 80/21

(45) Mention de la délivrance du brevet :
03.04.85 Bulletin 85/14

(84) Etats contractants désignés :
**AT BE CH DE GB IT LI LU NL SE**

(56) Documents cités :
**US-A- 3 644 740
US-A- 3 898 452
THE REVIEW OF SCIENTIFIC INSTRUMENTS, vol. 41,
no. 8, août 1970 NEW YORK (US) DOBRATZ et
FRANSWORTH: "Constant false alarm rate bias
control for an avalanche photodiode laser receiver",
pages 1191-1195
I.E.E.E. TRANSACTIONS ON ELECTRON DEVICES,
vol. ED-14, no. 5, mai 1967 NEW YORK (US) BIARD et
SHAUNFIELD: "A model of the avalanche photodiode", pages 233-238
Pulse, Digital and Switching Waveforms, MacGraw
Hill, 1965, page 248, 7-11
Le dossier contient des informations techniques présentées postérieurement au dépôt de la demande et
ne figurant pas dans le présent fascicule.**

(73) Titulaire : **SOCIETE D'ETUDES RECHERCHES ET
CONSTRUCTIONS ELECTRONIQUES SERCEL
Avenue du Bel Air Zone Industrielle
F-44470 Carquefou (FR)**

(72) Inventeur : **Le Helloco, Guy Yves Marie
"Le Tilleuls" Boisabeau
F-44390 Petit Mars (FR)**
Inventeur : **Le Roch, Jean-Paul Louis Marie
Boisabeau
F-44390 Petit Mars (FR)**

(74) Mandataire : **Martin, Jean-Jacques et al
Cabinet REGIMBEAU 26, Avenue Kléber
F-75116 Paris (FR)**

Jouve, 18, rue St-Denis, 75001 Paris, France

**Description**

La présente invention concerne les dispositifs photorécepteurs, et s'applique en particulier aux télécommunications et en télémétrie électro-optique.

On connaît déjà des dispositifs photorécepteurs comportant un transducteur photoélectrique à facteur multiplicateur variable par polarisation, tel qu'une photodiode à avalanche ou un tube photomultiplicateur. A ce transducteur sont ajoutés un circuit commandé de polarisation, un amplificateur principal monté entre la sortie du photomultiplicateur et la borne de sortie du dispositif photorécepteur, et une chaîne d'asservissement de polarisation montée entre la sortie de l'amplificateur principal et l'entrée de commande du circuit de polarisation.

Un tel dispositif est par exemple décrit dans le document « The Review of Scientific Instruments », volume 41, n° 8, août 1978.

Différentes structures ont été proposées pour la chaîne d'asservissement. Le plus souvent en vue de compenser l'effet des variations de température sur le facteur multiplicateur du transducteur. De telles chaînes d'asservissement visent donc à stabiliser le point de polarisation du transducteur qui est en général une photodiode à avalanche.

De nombreuses applications, et en particulier la télémétrie électro-optique, nécessitent que l'on obtienne un excellent rapport signal sur bruit. En effet, les télémètres électro-optiques opèrent à l'heure actuelle à très grande distance, et c'est le rapport signal sur bruit du transducteur photorécepteur qui définit la distance maximale de fonctionnement convenable.

La présente invention a essentiellement pour but de fournir un dispositif photorécepteur présentant un rapport signal sur bruit très adapté.

La demanderesse a observé que, dans un dispositif récepteur du type précité, la borne de sortie donne finalement le signal utile, un bruit multiplié par le transducteur, dû à l'éclairement ambiant ainsi qu'à des caractéristiques propres du transducteur, et un bruit non multiplié par le transducteur, dû seulement à des caractéristiques propres du transducteur et de l'amplificateur principal.

Cette analyse est également développée dans le document IEEE Transactions ou Electron Devices Vol. ED 14, N° 5, mai 1967.

Le dispositif photorécepteur pour signal utile à bande étroite conforme à l'invention est du type comprenant un transducteur photomultiplicateur associé à un circuit de polarisation commandée qui en règle le facteur multiplicateur, un amplificateur principal monté entre la sortie du photomultiplicateur et la borne de sortie du dispositif photorécepteur, ainsi qu'une chaîne d'asservissement de polarisation montée entre la sortie de l'amplificateur principal et l'entrée de commande du circuit de polarisation, dispositif dans lequel,

— étant observé que la borne de sortie donne finalement le signal utile, de niveau $N_s$, un bruit multiplié par le transducteur de niveau $N_b$, dû à l'éclairement ambiant ainsi qu'à des caractéristiques propres du transducteur, et un bruit non multiplié par le transducteur, de niveau $N_x$, dû seulement à des caractéristiques propres du transducteur et de l'amplificateur principal, ces niveaux de bruit étant rapportés à la même largeur de bande de référence,

— la chaîne d'asservissement comporte :

un circuit détecteur de niveau relié à la sortie de l'amplificateur pour en détecter le niveau de sortie d'ensemble $N_s + N_b + N_x$,

un générateur de signal auxiliaire de niveau prédéterminé lié à un niveau de référence K, et un

comparateur dont les deux entrées reçoivent respectivement la sortie du circuit détecteur et un signal tiré de la sortie du générateur de signal auxiliaire, tandis que sa sortie commande le circuit de polarisation, pour que celui-ci fasse respecter la relation :

$$N_s + N_b + N_x = K,$$

— le dispositif étant caractérisé selon l'invention par le fait que

— le générateur de signal auxiliaire produit un signal dont la bande de fréquences est disjointe de celle du signal utile du transducteur,

— ce signal est appliqué à l'entrée de l'amplificateur principal avec la sortie du phototransducteur,

— le circuit détecteur comporte un filtre coupe-bande relié à la sortie de l'amplificateur principal, éliminant le signal auxiliaire et suivi d'un étage détecteur de niveau, ainsi qu'un filtre passe-bande relié à la sortie de l'amplificateur principal, sélectionnant le signal auxiliaire et suivi d'un second étage détecteur de niveau, et

— le comparateur reçoit en entrée les sorties respectives des deux étages détecteurs de niveau, de telle sorte que :

— lorsque le niveau $N_s$ du signal utile est très inférieur aux niveaux de bruit $N_b$ et $N_x$, la condition d'asservissement est $N_b + N_x = K$,

— lorsque le niveau $N_s$ du signal utile est du même ordre que celui des bruits, étant observé que le bruit amplifié est alors négligeable, l'asservissement fonctionne en contrôle automatique de gain afin de maintenir sensiblement constant le signal de sortie du dispositif photorécepteur,

— tandis que lorsque le niveau $N_s$ du signal utile est largement supérieur aux niveaux $N_b$ et $N_x$ des bruits, le circuit de polarisation produit une polarisation prédéterminée correspondant à un facteur multiplicateur minimal.

En faisant transiter le signal auxiliaire par l'amplificateur principal, on s'affranchit des dérives en températures des circuits électroniques, puisque ce signal auxiliaire traverse les mêmes étages amplificateurs que le signal utile et les bruits. Très avantageusement, la multiplication du niveau de signal utile par le transducteur étant proportionnelle à $M^2$, et la multiplication du niveau de bruit par le transducteur étant proportionnelle à $M^d$, où d est une grandeur liée au transducteur, et qui évolue entre 2,3 et 3 en fonction du facteur multiplicateur M, K est inférieur à

$$d/(d - 2) = N_x.$$

Il s'est également avéré avantageux que la chaîne d'asservissement comporte un amplificateur à large bande inséré entre la sortie de l'amplificateur principal et les entrées des deux circuits détecteurs.

Dans un mode de réalisation particulier le signal auxiliaire est un signal alternatif sinusoïdal.

Ladite polarisation prédéterminée imposée par le circuit de polarisation lorsque le niveau $N_s$ du signal utile est largement supérieur aux niveaux $N_b$ et $N_x$ des bruits est avantageusement choisie pour définir un facteur multiplicateur égal à quelques unités environ.

Le transducteur photoélectrique utilisé selon la présente invention est de préférence une photodiode à avalanche, mais on peut également utiliser un tube photomultiplicateur.

D'autres caractéristiques et avantages de l'invention apparaîtront à la lecture de la description détaillée qui va suivre, faite en référence aux dessins annexés, sur lesquels :

la Figure 1   est le schéma de principe d'un dispositif photorécepteur selon la présente invention ;

la Figure 2   est un schéma électrique équivalent permettant de définir le niveau du signal utile du transducteur, le niveau du bruit amplifié par le transducteur, et le niveau du bruit non amplifié par celui-ci ;

la Figure 3   est le schéma électrique de principe d'un mode de réalisation préférentiel de l'invention ; et

les Figures 4 et 5   sont différents diagrammes illustrant les relations entre des grandeurs entrant en ligne de compte selon l'invention.

La description détaillée qui va suivre vise une application de télémétrie électro-optique.

On sait que ces télémètres utilisent un rayon lumineux modulé en amplitude à une fréquence assez élevée, voisine de 10 MHz en général. Un photo-récepteur permet de retrouver le signal de modulation, qui est immédiatement appliqué à un étage amplificateur à faible bruit. La demanderesse a observé que la puissance équivalente au bruit de l'ensemble comprenant une photodiode semi-conductrice classique et un étage amplificateur à faible bruit, ramenée à l'entrée de la photodiode, était largement supérieure à la puissance de bruit de la photodiode classique elle-même. Il apparaît donc que la limitation sur le plan du bruit d'un dispositif photorécepteur à photodiode classique est due au premier étage amplificateur qui suit la diode.

La demanderesse a observé également que l'emploi du gain d'avalanche dans une photodiode à avalanche permet d'augmenter le signal de sortie de la photodiode, et par là de réduire l'effet du bruit de l'amplificateur qui la suit. Le problème pratique est qu'au delà d'un certain seuil, variable avec la température, l'augmentation du facteur multiplicateur de la photodiode à avalanche s'accompagne d'une augmentation très rapide du bruit.

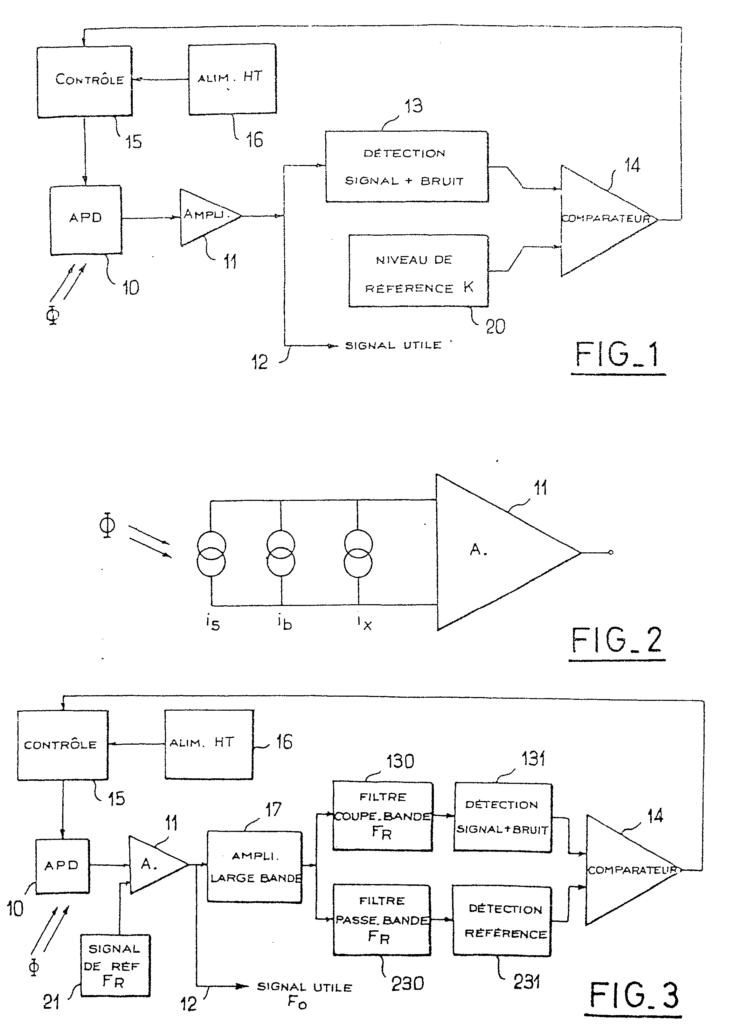

La Figure 1 illustre le schéma de principe d'un dispositif photodétecteur selon l'invention. Classiquement, une photodiode à avalanche 10 reçoit un flux lumineux Ø constitué par exemple d'un faisceau infrarouge modulé à une fréquence F de l'ordre de 10 MHz. La sortie de la photodiode 10, dont un signal électrique de fréquence F, est appliquée à un amplificateur principal ; et la sortie de celui-ci donne sur la borne de sortie 12, en plus des bruits, un signal utile qui sera traité ensuite par les circuits de réception d'un télémètre.

La photodiode à avalanche 10 reçoit une tension de polarisation définie par le circuit de commande de polarisation 15, à partir d'un circuit d'alimentation haute tension 16 (les tensions de polarisation atteignent couramment la centaine de volts).

La demanderesse a fait différentes observations, à partir du schéma équivalent de la Figure 2 qui est une représentation en sources de courant de l'entrée de l'amplificateur principal 11 :

— $i_s$ désigne le courant associé au signal utile ;

— $i_b$ désigne le courant associé au bruit multiplié par la photodiode, car dépendant de l'avalanche, et

— $i_x$ désigne le courant associé au bruit non multiplié par l'avalanche.

Le courant de signal utile $i_s$ dépend du photocourant utile $I_{ph}$, dans la photodiode, de l'indice de modulation m du faisceau lumineux reçu, ainsi que du facteur multiplicateur M de la photodiode à avalanche ; la valeur moyenne du niveau de signal utile s'écrit :

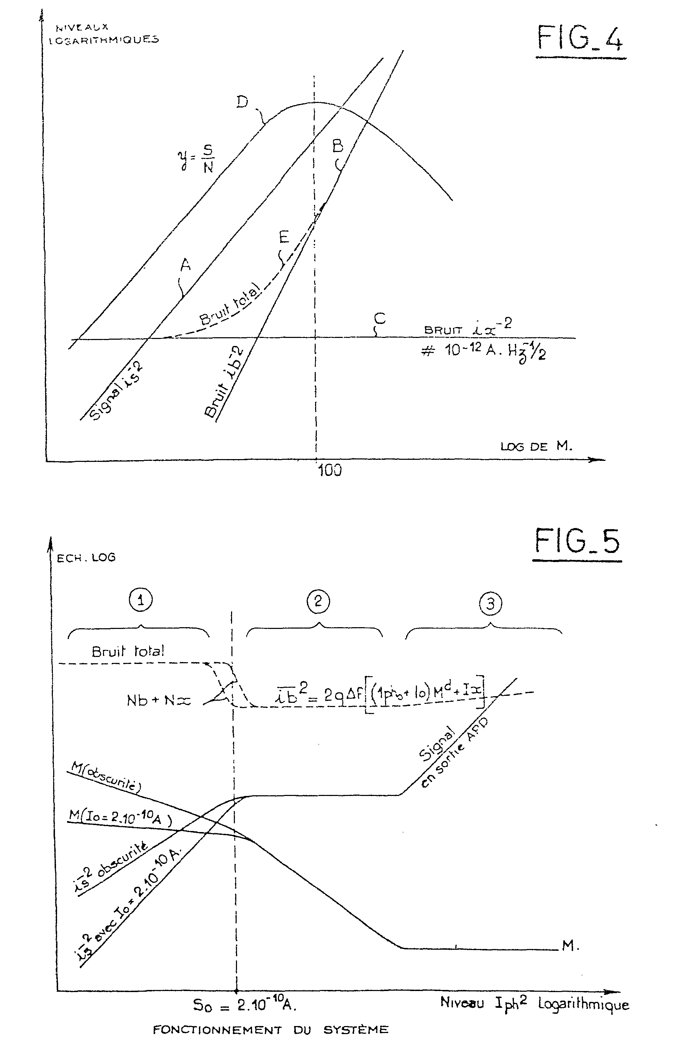

$$N_s = \overline{i_s}^2 = (I_{ph})^2 \cdot m^2 \cdot M^2/2 \quad \text{(courbe A ; Figure 4)}$$

3

Le courant de bruit amplifié $i_b$ dépend de la somme $I_{pho} + I_o$ du photocourant total $I_{pho}$ pour M = 1 (y compris l'éclairement ambiant), et du courant de fuite en volume $I_o$ de la photodiode, de la largeur de bande $\Delta f$, de la charge q d'un électron, et d'un coefficient d, compris généralement entre 2,3 et 3, et caractéristique de la photodiode.

La valeur moyenne du niveau de bruit amplifié peut s'écrire :

$$Nb = \overline{i_b}^2 = 2 \cdot q \cdot \Delta f \cdot (I_{pho} + I_o) \cdot M^d \text{ (courbe B ; Figure 4)}$$

Enfin, le courant de bruit non amplifié $i_x$ dépend de la résistance série de la photodiode, de son courant de fuite de surface, et du courant de bruit de l'étage amplificateur, ramené à son entrée. Ces paramètres, qui peuvent être connus à l'avance, sont notés $I_x$. La valeur moyenne du niveau de bruit non amplifié s'écrit :

$$N_x = \overline{i_x}^2 = 2 \cdot q \cdot I_x \cdot \Delta f \text{ (courbe C ; Figure 4)}$$

On notera que $N_x$ est connu à l'avance.

En écrivant le rapport signal sur bruit $y = N_s/(N_b + N_x)$, on observe que celui-ci est maximal (courbe D : Figure 4) pour

$$M^d = (I_x/I_o) \cdot [2/(d - 2)]$$

La demanderesse a finalement remarqué qu'à cette relation correspond la condition suivante sur le bruit total :

$$Nb + N_x = [d/(d - 2)] N_x \text{ (Courbe E ; Figure 4)}$$

L'expérience a cependant montré que, pour éviter des instabilités, il est important de prendre $N_b + N_x = K$ où K est inférieur à $[d/(d - 2)] N_x$, qui est connu à l'avance. Pour certaines applications, des valeurs de K très voisines de $[d/(d - 2)] N_x$ peuvent convenir, mais il est généralement souhaitable de prendre une valeur de K qui ne soit pas trop proche de

$$[d/(d - 2)] N_x.$$

On reviendra maintenant à la réalisation de la Figure 1.

Un circuit détecteur 13 (Figure 1) redresse la sortie de l'amplificateur principal 11, fournissant donc un niveau :

$$N_s + N_b + N_x$$

signal qui est appliqué à une première entrée d'un comparateur 14.

Un circuit de référence 20 produit un niveau auxiliaire de référence, prédéterminé, égal à K, appliqué à la seconde entrée du comparateur 14.

Celui-ci agit donc sur le circuit de polarisation 15 en tant qu'asservissement de constante de temps convenable pour faire respecter la relation :

$$N_s + N_b + N_x = K.$$

On voit immédiatement que cette condition n'est pas identique à $N_b + N_x = K$. Elle se confond cependant avec elle aux faibles valeurs du signal utile (zone 1 ; Figure 5), là où un très bon rapport signal sur bruit est important. Et elle est très simple à réaliser, ne nécessitant aucune séparation du signal utile et des différents bruits.

Aux valeurs intermédiaires du signal utile (frontières zones 1 et 2 ; Figure 5), pour lesquelles le bruit amplifié n'est pas encore négligeable devant le signal utile, les niveaux de signal utile $N_s$ et de bruit multiplié $N_b$ participent ensemble à l'asservissement du facteur multiplicateur M, ce qui fournit une commande automatique de gain, propriété intéressante en particulier dans les télémètres. Dans la zone 2, la commande automatique de gain se fait essentiellement d'après le signal utile.

Enfin, en présence d'un fort signal utile (zone 3 ; Figure 5), le circuit de polarisation fixe une polarisation prédéterminée de la photodiode, correspondant à un faible facteur multiplicateur de l'ordre de quelques unités (5 par exemple).

En ce qui concerne le rapport $K/N_x = [d/(d - 2)]$ celui-ci doit être inférieur à 7,67 pour des photodiodes à avalanche où d = 2,3 dans la zone des gains intermédiaires ; cette limite descend progressivement aux valeurs extrêmes du gain ou pour des photodiodes dont d minimum est plus grand que 2,3.

La demanderesse a considéré que la valeur $K = 2 \cdot N_x$ est satisfaisante pour l'application aux télémètres, et convient pour la quasi-totalité des photodiodes à avalanche actuellement disponibles.

4

0 017 596

On remarquera qu'avec $K = 2 \cdot N_x$, la condition d'asservissement s'écrit $N_s + N_b = N_x$. En présence d'un fort signal utile, le terme $N_b$ devient négligeable, et l'on obtient $N_s = N_x$. Corrélativement le rapport signal sur bruit est égal à l'unité, mais en considérant toute la largeur de bande $\Delta f$. Comme le signal utile occupe une petite largeur de bande (obtenue par filtrage dans des circuits récepteurs du télémètre, non représentés), il suffit de choisir $\Delta f$ suffisamment grand pour avoir le rapport signal sur bruit désiré.

La Figure 5 résume le fonctionnement de l'asservissement et illustre schématiquement les variations en échelle logarithmique de M, $(N_b + N_x)$ et $N_s$ en fonction du niveau de photocourant utile $(I_{ph})^2$ pour $M = 1$, également en échelle logarithmique :
— pour $(I_{ph})^2 < S_o$, l'asservissement maintient $N_b = N_x$ ; le facteur M décroît avec le niveau de signal $(I_{ph})^2$ tandis que le rapport signal sur bruit y croît (zone 1) ; on voit l'influence de l'éclairement ambiant $I_o$.
— à partir de $(I_{ph})^2 = S_o$ (zone 2), le rapport signal bruit y est maintenu constant ; de son côté, le facteur M continue à décroître, et avec lui le bruit amplifié par la photodiode $N_b$.

Dans la zone 3, le gain M est constant, et l'asservissement n'agit plus. L'ajustement du niveau de signal peut se faire, si nécessaire, en agissant sur la transmission optique du système (diaphragme ; filtre gris) ou sur le gain de l'électronique en aval de 12.

On décrira maintenant, en référence à la Figure 3, le mode de réalisation actuellement préféré de l'invention.

Le signal de référence est appliqué à l'entrée de l'amplificateur principal 11, avec le signal de sortie de la photodiode 10. Il conserve le niveau $2 \cdot N_x$, en tenant compte des facteurs d'amplification concernés ; mais il est constitué d'un signal situé dans une bande de fréquences extérieur à celle du signal utile. De préférence, c'est un signal sinusoïdal pur dont la fréquence $F_r$ est de l'ordre de 7 à 8 MHz.

La sortie de l'amplificateur principal 11 est appliquée à un amplificateur auxiliaire à large bande 17, suivi du circuit détecteur 13 précité, lequel comporte maintenant un filtre coupe-bande éliminant la bande de fréquences du signal de référence, puis un détecteur de niveau 131, dont la sortie arrive à la première entrée du comparateur 14.

Un second ensemble détecteur, également connecté à la sortie de l'amplificateur à large bande 17, comprend un filtre passe bande 230, sélectionnant la bande de fréquences du signal de référence, puis un détecteur de niveau 231, dont la sortie est connectée à la seconde entrée du comparateur 14.

Le fonctionnement est le même que pour le dispositif de la Figure 1. Mais la réalisation de la Figure 3 élimine l'effet des dérives en température des circuits électroniques, puisque le signal de référence traverse les mêmes étages amplificateurs que le signal et le bruit.

En allant très près du rapport signal sur bruit optimal, aux faibles niveaux du signal utile, le dispositif de l'invention améliore sensiblement les performances d'un dispositif photorécepteur à photodiode à avalanche. Celui-ci s'applique en particulier aux télémètres électro-optiques opérant à grande distance, et ce quel que soit l'éclairement ambiant.

**Revendications**

1. Dispositif photorécepteur pour signal utile à bande étroite, du type comprenant un transducteur photomultiplicateur (10) associé à un circuit de polarisation commandée (15, 16) qui en règle le facteur multiplicateur, un amplificateur principal (11) monté entre la sortie du photomultiplicateur et la borne de sortie (12) du dispositif photorécepteur, ainsi qu'une chaîne d'asservissement de polarisation montée entre la sortie de l'amplificateur principal (11) et l'entrée de commande du circuit de polarisation, dispositif dans lequel,
— étant observé que la borne de sortie donne finalement le signal utile, de niveau $N_s$, un bruit multiplié par le transducteur de niveau $N_b$, dû à l'éclairement ambiant ainsi qu'à des caractéristiques propres du transducteur, et un bruit non multiplié par le transducteur, de niveau $N_x$, dû seulement à des caractéristiques propres du transducteur et de l'amplificateur principal, ces niveaux de bruit étant rapportés à la même largeur de bande de référence,
— la chaîne d'asservissement comporte :
un circuit détecteur de niveau (130, 131) relié à la sortie de l'amplificateur (11) pour en détecter le niveau de sortie d'ensemble $N_s + N_b + N_x$,
un générateur de signal auxiliaire (21) de niveau prédéterminé lié à un niveau de référence K, et un comparateur (14) dont les deux entrées reçoivent respectivement la sortie du circuit détecteur (130, 131) et un signal tiré de la sortie du générateur de signal auxiliaire (21, 230, 231), tandis que sa sortie commande le circuit de polarisation (15), pour que celui-ci fasse respecter la relation :

$$N_s + N_b + N_x = K,$$

caractérisé par le fait que :
— le générateur de signal auxiliaire (21) produit un signal (FR) dont la bande de fréquences est disjointe de celle du signal utile du transducteur,
— ce signal est appliqué à l'entrée de l'amplificateur principal (11) avec la sortie du phototransducteur,

5

— le circuit détecteur comporte un filtre coupe-bande (130) relié à la sortie de l'amplificateur principal (11), éliminant le signal auxiliaire et suivi d'un étage détecteur de niveau (131), ainsi qu'un filtre passe-bande (230) relié à la sortie de l'amplificateur principal (11), sélectionnant le signal auxiliaire et suivi d'un second étage détecteur de niveau (231), et

— le comparateur (14) reçoit en entrée les sorties respectives des deux étages détecteur de niveau (131, 231),

de telle sorte que :

— lorsque le niveau $N_s$ du signal utile est très inférieur aux niveaux de bruit $N_b$ et $N_x$, la condition d'asservissement est $N_b + N_x = K$,

— lorsque le niveau $N_s$ du signal utile est du même ordre que celui des bruits, étant observé que le bruit amplifié est alors négligeable, l'asservissement fonctionne en contrôle automatique de gain afin de maintenir sensiblement constant le signal de sortie du dispositif photorécepteur,

— tandis que lorsque le niveau $N_s$ du signal utile est largement supérieur aux niveaux $N_b$ et $N_x$ des bruits, le circuit de polarisation (15) produit une polarisation prédéterminée correspondant à un facteur multiplicateur minimal.

2. Dispositif photorécepteur selon la revendication 1, caractérisé par le fait que, la multiplication du niveau de signal utile par le transducteur (10) étant proportionnelle à $M^2$, et la multiplication du niveau de bruit par le transducteur étant proportionnelle à $M^d$, où d est une grandeur liée au transducteur, et qui évolue entre 2,3 et 3 en fonction du facteur multiplicateur M, K est inférieur à $[d/(d-2)]\,N_x$.

3. Dispositif photorécepteur selon la revendication 2, caractérisé par le fait que $K = 2 \cdot N_x$.

4. Dispositif photorécepteur selon l'une des revendications 1 à 3, caractérisé par le fait que la chaîne d'asservissement comporte un amplificateur à large bande (17) inséré entre la sortie de l'amplificateur principal (11) et les entrées respectives du filtre coupe-bande (130) et du filtre passe-bande (230).

5. Dispositif photorécepteur selon l'une des revendications 1 à 4, caractérisé par le fait que le signal auxiliaire ($F_R$) est un signal alternatif sinusoïdal.

6. Dispositif photorécepteur selon l'une des revendications 1 à 5, caractérisé par le fait que le transducteur photoélectrique (10) est une photodiode à avalanche.

7. Dispositif photorécepteur selon l'une des revendications 1 à 5, caractérisé par le fait que le transducteur photoélectrique (10) est un tube photomultiplicateur.

8. Utilisation du dispositif selon l'une des revendications 1 à 7 dans un télémètre électro-optique.

## Claims

1. Photoreceiver device for a narrow band useful signal, of the type comprising a photomultiplier transducer (10) associated with a controlled polarisation circuit (15, 16) which regulates the multiplier factor thereof, a main amplifier (11) connected between the output of the photomultiplier and the output terminal (12) of the photoreceiver device as well as a polarisation control chain connected between the output of the main amplifier (11) and the control input of the polarisation circuit, a device in which,

— it being noted that the output terminal finally gives the useful signal, of level $N_s$, a noise multiplied by the transducer of level $N_b$; due to the ambient illumination as well as to inherent characteristics of the transducer and a noise not multiplied by the transducer, of level $N_x$, due solely to inherent characteristics of the transducer and of the main amplifier, these noise levels being assigned to the same width of reference band,

— the control chain comprises :

a level detector circuit (130, 131) connected to the output of the amplifier (11) for detecting the general output level there of $N_s + N_b + N_x$,

an auxiliary signal generator (21) of predetermined level linked with a reference level K and

a comparator (14) where of the two inputs respectively receive the output of the detector circuit (130, 131) and a signal drawn from the output of the auxiliary signal generator (21, 230, 231), where as its output controls the polarisation circuit (15), in order that the latter respects the relationship :

$$N_s + N_b + N_x = K,$$

characterised by the fact that :

— the auxiliary signal generator (21) produces a signal (FR) where of the frequency band is separated from that of the useful signal of the transducer.

— this signal is applied to the input of the main amplifier (11) with the output of the phototransducer,

— the detector circuit comprises a band-cut filter (130) connected to the output of the main amplifier (11), eliminating the auxiliary signal and followed by a level detector stage (131), as well as a band-pass filter (230) connected to the output of the main amplifier (11), selecting the auxiliary signal and followed by a second level detector stage (231) and

— the comparator (14) receives at its input the respective outputs of the two level detector stages (131, 231),

so that :

— when the level $N_s$ of the useful signal is much less than the noise levels $N_b$ and $N_x$, the control condition is $N_b + N_x = K$,

— when the level $N_s$ of the useful signal is of the same order as that of the noises, it being noted that the amplified noise is then negligible, the control operates with automatic gain control in order to keep the output signal of the photoreceiver device substantially constant,

— where as when the level $N_s$ of the useful signal is much higher than the levels $N_b$ and $N_x$ of the noises, the polarisation circuit (15) produces a predetermined polarisation corresponding to a minimal multiplier factor.

2. Photoreceiver device according to Claim 1, characterised by the fact that since the multiplication of the useful signal level by the transducer (10) is proportional to $M^2$ and the multiplication of the noise level by the transducer is proportional to $M^d$, where d is a value linked with the transducer and which evolves between 2.3 and 3 depending on the multiplier factor M, K is less than $(d/d - 2) N_x$.

3. Photoreceiver device according to Claim 2, characterised by the fact that $K = 2 \cdot N_x$.

4. Photoreceiver device according to one of Claims 1 to 3, characterised by the fact that the control chain comprises a wide band amplifier (17) inserted between the output of the main amplifier (11) and the respective inputs of the band-cut filter (130) and of the band-pass filter (230).

5. Photoreceiver device according to one of Claims 1 to 4, characterised by the fact that the auxiliary signal ($F_R$) is an alternating sinusoidal signal.

6. Photoreceiver device according to one of Claims 1 to 5, characterised by the fact that the photoelectric transducer (10) is an avalanche photo diode.

7. Photoreceiver device according to one of Claims 1 to 5, characterised by the fact that the photoelectric transducer (10) is a photomultiplier tube.

8. Use of the device according to one of Claims 1 to 7 in an electro-optical range-finder.

**Ansprüche**

1. Photoempfänger für ein schmalbandiges Nutzsignal, enthaltend einen photovervielfachenden Wandler (10), der einem Kreis (15, 16) gesteuerter Vorspannung zugeordnet ist, der seinen Vervielfachungsfaktor beeinflußt, einen Hauptverstärker (11), der zwischen dem Ausgang des Photovervielfachers und der Ausgangsklemme (12) des Photoempfängers angeordnet ist, sowie eine Vorspannungsregelschleife, die zwischen den Ausgang des Hauptverstärkers (11) und den Steuereingang des Vorspannungskreises geschaltet ist, wobei,

— wenn beobachtet wird, daß die Ausgangsklemme schließlich das Nutzsignal vom Pegel $N_s$, ein vom Wandler vervielfachtes Rauschen vom Pegel $N_b$ aufgrund von Umgebungsbeleuchtung und der Eigencharakteristik des Wandlers, und ein vom Wandler nicht vervielfachtes Rauschen vom Pegel $N_x$ allein aufgrund der Eigencharakteristik des Wandlers und des Hauptverstärkers abgibt, diese Rauschpegel auf dieselbe Bezugsbandbreite bezogen sind,

— die Regelschleife enthält :

einen Pegeldetektorkreis (130, 131), der mit dem Ausgang des Verstärkers (11) verbunden ist, um daraus den Ausgangspegel der Gesamtheit $N_s + N_b + N_x$ zu ermitteln,

einen Generator für ein Hilfssignal (21) vorbestimmten Pegels, der mit einem Vergleichspegel K verknüpft ist, und einen

Komparator (14), dessen zwei Eingänge den Ausgang des Detektorkreises (130, 131) und ein Signal erhalten, das vom Ausgang des Hilfssignalgenerators (21, 230, 231) bezogen ist, während sein Ausgang den Vorspannungskreis (15) steuert, damit dieser der Beziehung genügt :

$$N_s + N_b + N_x = K,$$

dadurch gekennzeichnet, daß :

— der Hilfssignalgenerator (21) ein Signal (FR) erzeugt, dessen Frequenzband von demjenigen des Nutzsignales des Wandlers getrennt ist,

— das Signal dem Eingang des Hauptverstärkers (11) mit dem Ausgang des Photowandlers zugeführt ist,

— der Detektorkreis ein Bandsperrfilter (130) enthält, das mit dem Ausgang des Hauptverstärkers (11) verbunden ist und das Hilfssignal beseitigt und von einer Pegeldetektorstufe (131) gefolgt wird, weiterhin ein Bandpaßfilter (230) enthält, das mit dem Ausgang des Hauptverstärkers (11) verbunden ist und das Hilfssignal hervorhebt und von einer zweiten Pegeldetektorstufe (231) gefolgt wird, und

— der Komparator (14) als Eingänge die Ausgänge der zwei Pegeldetektorstufen (131, 231) erhält, so daß :

— wenn der Pegel $N_s$ des Nutzsignals stark unter den Rauschpegeln $N_b$ und $N_x$ liegt, die Regelbedingung $N_b + N_x = K$ ist,

— wenn der Pegel $N_s$ des Nutzsignals in der gleichen Größenordnung wie der der Rauschsignale liegt, wobei beobachtet wird, daß das verstärkte Rauschen daher vernachlässigbar ist, die Regelung als automatische Verstärkungsregelung arbeitet, um das Ausgangssignal des Photoempfängers im wesentlichen konstant zu halten,

7

— während wenn der Nutzsignalpegel $N_s$ stark über den Rauschpegeln $N_b$ und $N_x$ liegt, der Vorspannungskreis (15) eine vorbestimmte Vorspannung erzeugt, die einem minimalen Vervielfachungsfaktor entspricht.

2. Photoempfänger nach Anspruch 1, dadurch gekennzeichnet, daß die Vervielfachung des Nutzsignalpegels durch den Wandler (10) proportional $M^2$ ist und die Vervielfachung des Rauschsignalpegels durch den Wandler proportional $M^d$ ist, wobei d eine mit dem Wandler verbundene Größe ist, die zwischen 2,3 und 3 als Funktion des Vervielfachungsfaktors M liegt, K kleiner als $(d/d - 2) N_x$ ist.

3. Photoempfänger nach Anspruch 2, dadurch gekennzeichnet, daß $K = 2 \cdot N_x$.

4. Photoempfänger nach einem der Ansprüche 1 bis 3, dadurch gekennzeichnet, daß die Regelschleife einen Breitbandverstärker (17) aufweist, der zwischen den Ausgang des Hauptverstärkers (11) und die Eingänge des Bandsperrfilters (130) und des Bandpaßfilters (230) geschaltet ist.

5. Photoempfänger nach einem der Ansprüche 1 bis 4, dadurch gekennzeichnet, daß das Hilfssignal (FR) ein sinusförmiges Wechselsignal ist.

6. Photoempfänger nach einem der Ansprüche 1 bis 5, dadurch gekennzeichnet, daß der photoelektrische Wandler (10) eine Lawinendiode ist.

7. Photoempfänger nach einem der Ansprüche 1 bis 5, dadurch gekennzeichnet, daß der photoelektrische Wandler (10) eine Photovervielfacherröhre ist.

8. Anwendung des Photoempfängers nach einem der Ansprüche 1 bis 7 in einem elektrooptischen Entfernungsmesser.

FIG_1

FIG_2

FIG_3

FIG_4

FIG_5